# EUROPEAN PATENT APPLICATION

(11) **EP 4 246 805 A1**
(43) Date of publication of application: **20.09.2023**
(21) Application number: 22759963.6
(22) Date of filing: 15.02.2022
(51) Int. Cl.: H03F 1/56, H03F 3/21, H04B 1/00, H04B 1/401

(54) **COMMUNICATION CIRCUIT INCLUDING AMPLIFIER MODULE, AND ELECTRONIC DEVICE COMPRISING SAME**

(30) Priority: 23.02.2021 KR 20210024353
(71) Applicant: Samsung Electronics Co., Ltd., Suwon-si, Gyeonggi-do 16677 (KR)
(72) Inventor: MOON, John, Suwon-si, Gyeonggi-do 16677 (KR); YANG, Dongil, Suwon-si, Gyeonggi-do 16677 (KR); NA, Hyoseok, Suwon-si, Gyeonggi-do 16677 (KR); AN, Yongjun, Suwon-si, Gyeonggi-do 16677 (KR)
(74) Representative: Gulde & Partner
(86) International application number: PCT/KR2022/002224
(87) International publication number: WO 2022/182045

(57) **Abstract**

In a communication circuit and an electronic device comprising the communication circuit according to various embodiments, the communication circuit comprises: an amplifier module including a first amplifier and a second amplifier for amplifying a signal amplified by the first amplifier; and a first matching circuit that is disposed outside the amplifier module and performs impedance matching between the first amplifier and the second amplifier, wherein the amplifier module includes a first terminal for outputting, to the outside, the signal amplified by the first amplifier, and a second terminal for a signal that is input to the second amplifier, and the first matching circuit may be connected to the amplifier module via the first terminal and the second terminal. Various other embodiments are also possible.

## Description

### [Technical Field]

Various embodiments of the disclosure relate to a communication circuit including an amplifier module, and an electronic device.

### [Background Art]

Various electronic devices, such as smartphones, tablet personal computers (PCs), portable multimedia players (PMPs), personal digital assistants (PDAs), laptop PCs or wearable devices are being supplied.

An electronic device may include a communication circuit for communication with an external electronic device. The communication circuit may include an amplifier module for amplifying a transmission signal. The amplifier module may include two or more amplifiers to meet a required strength of the transmission signal. Two or more amplifiers may be connected in a cascade form, and the amplifier module may perform signal amplification to output a transmission signal having a required strength.

### [Disclosure of Invention]

### [Technical Problem]

An amplifier module including amplifiers connected in a cascade form may include a matching circuit for impedance matching between the amplifiers. The matching circuit is a circuit having an impedance that is changed according to the frequency band of a transmission signal, and may be designed in consideration of the frequency band of a signal amplified by the amplifier module. The frequency band supportable by the amplifier module may be determined based on characteristics of amplifiers and matching circuits in the amplifier module. For example, considering that the amplifiers in the amplifier module can support a wider frequency band than the matching circuit, the frequency band that the amplifier module can support can be more influenced by the matching circuit.

The matching circuit included in an amplifier module may be designed in consideration of the frequency band of a signal amplified by the amplifier module. Hence, it may be difficult for the amplifier module to amplify a signal of a frequency band other than the frequency band that the amplifier module can support.

In a communication circuit and an electronic device including the communication circuit according to various embodiments of the disclosure, at least a portion of the matching circuit performing impedance matching between amplifiers in the amplifier module is implemented outside the amplifier module, so that the frequency band supported by the amplifier module can be changed.

### [Solution to Problem]

A communication circuit according to various embodiments of the disclosure may include: an amplifier module including a first amplifier and a second amplifier for amplifying a signal amplified by the first amplifier; and a first matching circuit disposed outside the amplifier module and performing impedance matching between the first amplifier and the second amplifier, wherein the amplifier module may include a first terminal for outputting a signal amplified by the first amplifier to an outside, and a second terminal for a signal input to the second amplifier, and wherein the first matching circuit may be connected to the amplifier module through the first terminal and the second terminal.

An electronic device according to various embodiments of the disclosure may include: a communication processor; a transceiver; and a communication circuit, wherein the communication circuit may include an amplifier module that includes a first amplifier and a second amplifier for amplifying a signal amplified by the first amplifier, and a first matching circuit disposed outside the amplifier module and performing impedance matching between the first amplifier and the second amplifier, wherein the amplifier module may include a first terminal for outputting a signal amplified by the first amplifier to an outside, and a second terminal for a signal input to the second amplifier, and wherein the first matching circuit may be connected to the amplifier module through the first terminal and the second terminal.

### [Advantageous Effects of invention]

In a communication circuit and an electronic device including the communication circuit according to various embodiments of the disclosure, the impedance matching circuit performing impedance matching between amplifiers of the amplifier module can be implemented outside the amplifier module. Since the impedance matching circuit is implemented outside the amplifier module, the communication circuit and the electronic device including the communication circuit can support amplification of signals of various frequency bands while using the same amplifier module.

The communication circuit and the electronic device including the communication circuit according to various embodiments of the disclosure may perform impedance matching between amplifiers within the amplifier module by using an impedance matching circuit disposed outside the amplifier module. Therefore, the communication circuit and the electronic device according to various embodiments of the disclosure may amplify signals of various frequency bands by controlling the impedance matching circuit without increasing the number of amplifier modules.

### [Brief Description of Drawings]

FIG. 1 is a block diagram of an electronic device according to various embodiments of the disclosure.
FIG. 2 is a block diagram of an electronic device for supporting legacy network communication and 5G network communication according to various embodiments.
FIG. 3 is a block diagram of an electronic device according to various embodiments of the disclosure.
FIG. 4 is a block diagram of an amplifier module according to various embodiments of the disclosure.
FIG. 5 is a diagram illustrating a communication circuit including an amplifier module and a first matching circuit performing impedance matching between a first amplifier and a second amplifier according to various embodiments of the disclosure.
FIG. 6 is a block diagram of a communication circuit including an amplifier module capable of amplifying signals of plural frequency bands according to various embodiments of the disclosure.
FIG. 7A and 7B are block diagrams of an electronic device including an amplifier module capable of amplifying signals of plural frequency bands according to various embodiments of the disclosure.
FIG. 8 is a block diagram of a communication circuit including an amplifier module according to various embodiments of the disclosure.

### [Mode for the Invention]

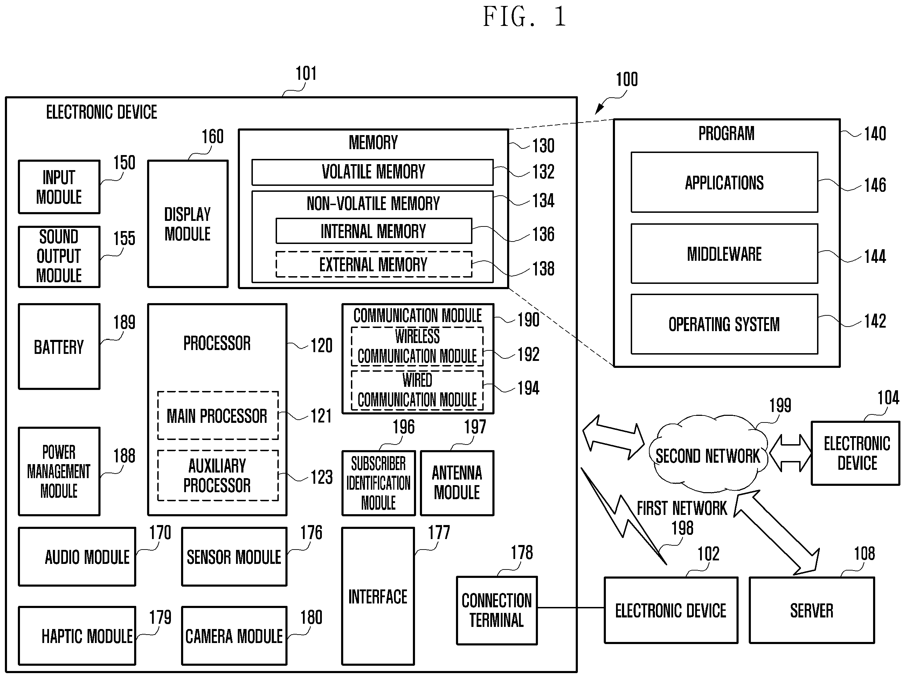

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

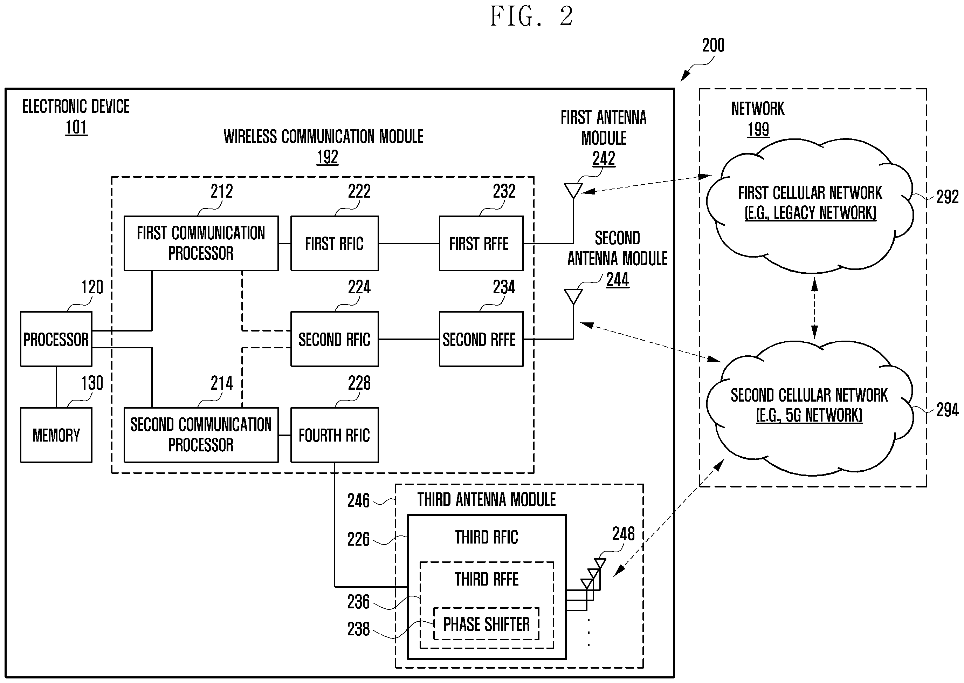

FIG. 2 is a block diagram 200 of an electronic device 101 for supporting legacy network communication and 5G network communication according to certain embodiments. Referring to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and an antenna 248. The electronic device 101 may further include the processor 120 and the memory 130. The network 199 may include a first network 292 and a second network 294. According to another embodiment, the electronic device 101 may further include at least one component among the components illustrated in FIG. 1, and the network 199 may further include at least one other network. According to an embodiment, the first communication processor 212, the second communication processor 214, the first RFIC 222, the second RFIC 224, the fourth RFIC 228, the first RFFE 232, and the second RFFE 234 may be included as at least a part of the wireless communication module 192. According to another embodiment, the fourth RFIC 228 may be omitted or may be included as a part of the third RFIC 226.

The first communication processor 212 may establish a communication channel of a band to be used for wireless communication with the first network 292, and may support legacy network communication via the established communication channel. According to certain embodiments, the first network may be a legacy network including 2G, 3G, 4G, or long term evolution (LTE) network. The second communication processor 214 may establish a communication channel corresponding to a designated band (e.g., approximately 6GHz to 60 GHz) among bands to be used for wireless communication with the second network 294, and may support 5G network communication via the established channel. According to certain embodiments, the second network 294 may be a 5G network defined in 3GPP. Additionally, according to an embodiment, the first communication processor 212 or the second communication processor 214 may establish a communication channel corresponding to another designated band (e.g., lower than 6GHz) among bands to be used for wireless communication with the second network 294, and may support 5G network communication via the established channel. According to an embodiment, the first communication processor 212 and the second communication processor 214 may be implemented in a single chip or a single package. According to certain embodiments, the first communication processor 212 or the second communication processor 214 may be implemented in a single chip or a single package, together with the processor 120, the sub-processor 123, or the communication module 190.

In the case of transmission, the first RFIC 222 may convert a baseband signal generated by the first communication processor 212 into a radio frequency (RF) signal in a range of approximately 700MHz to 3GHz used for the first network 292 (e.g., a legacy network). In the case of reception, an RF signal is obtained from the first network 292 (e.g., a legacy network) via an antenna (e.g., the first antenna module 242), and may be preprocessed via an RFFE (e.g., the first RFFE 232). The first RFIC 222 may convert the preprocessed RF signal to a baseband signal so that the base band signal is processed by the first communication processor 212.

In the case of transmission, the second RFIC 224 may convert a baseband signal generated by the first communication processor 212 or the second communication processor 214 into an RF signal (hereinafter, a 5G Sub6 RF signal) of a Sub6 band (e.g., lower than 6GHz) used for the second network 294 (e.g., 5G network). In the case of reception, a 5G Sub6 RF signal is obtained from the second network 294 (e.g., a 5G network) via an antenna (e.g., the second antenna module 244), and may preprocessed by an RFFE (e.g., the second RFFE 234). The second RFIC 224 may convert the preprocessed 5G Sub6 RF signal into a baseband signal so that the baseband signal is processed by a corresponding communication processor from among the first communication processor 212 or the second communication processor 214.

The third RFIC 226 may convert a baseband signal generated by the second communication processor 214 into an RF signal (hereinafter, a 5G Above6 RF signal) of a 5G Above6 band (e.g., approximately 6GHz to 60GHz) to be used for the second network 294 (e.g., 5G network). In the case of reception, a 5G Above6 RF signal is obtained from the second network 294 (e.g., a 5G network) via an antenna (e.g., the antenna 248), and may be preprocessed by the third RFFE 236. The third RFIC 226 may convert the preprocessed 5G Above6 RF signal to a baseband signal so that the base band signal is processed by the second communication processor 214. According to an embodiment, the third RFFE 236 may be implemented as a part of the third RFIC 226.

According to an embodiment, the electronic device 101 may include the fourth RFIC 228, separately from or as a part of the third RFIC 226. In this instance, the fourth RFIC 228 may convert a baseband signal generated by the second communication processor 214 into an RF signal (hereinafter, an IF signal) in an intermediate frequency band (e.g., approximately 9GHz to 11 GHz), and may transfer the IF signal to the third RFIC 226. The third RFIC 226 may convert the IF signal to a 5G Above6 RF signal. In the case of reception, a 5G Above6 RF signal is received from the second network 294 (e.g., a 5G network) via an antenna (e.g., the antenna 248), and may be converted into an IF signal by the third RFFE 226. The fourth RFIC 228 may convert the IF signal to a baseband signal so that the base band signal is processed by the second communication processor 214.

According to an embodiment, the first RFIC 222 and the second RFIC 224 may be implemented as a single chip or at least a part of the single package. According to an embodiment, the first RFFE 232 and the second RFFE 234 may be implemented as a single chip or at least a part of the single package. According to an embodiment, at least one antenna module of the first antenna module 242 or the second antenna module 244 may be omitted, or may be combined with another antenna module so as to process RF signals in a plurality of bands.

According to an embodiment, the third RFIC 226 and the antenna 248 may be disposed in the same substrate, and may form the third antenna module 246. For example, the wireless communication module 192 or the processor 120 may be disposed in a first substrate (e.g., main PCB). In this instance, the third RFIC 226 is disposed in a part (e.g., a lower part) of the second substrate (e.g., a sub PCB) separate from the first substrate and the antenna 248 is disposed on another part (e.g., an upper part), so that the third antenna module 246 is formed. By disposing the third RFIC 226 and the antenna 248 in the same substrate, the length of a transmission line therebetween may be reduced. For example, this may reduce a loss (e.g., attenuation) of a signal in a high-frequency band (e.g., approximate 6GHz to 60GHz) used for 5G network communication, the loss being caused by a transmission line. Accordingly, the electronic device 101 may improve the quality or speed of communication with the second network 294 (e.g., 5G network).

According to an embodiment, the antenna 248 may be implemented as an antenna array including a plurality of antenna elements which may be used for beamforming. In this instance, the third RFIC 226 may be, for example, a part of the third RFFE 236, and may include a plurality of phase shifters 238 corresponding to a plurality of antenna elements. In the case of transmission, each of the plurality of phase shifters 238 may shift the phase of a 5G Above6RF signal to be transmitted to the outside of the electronic device 101 (e.g., a base station of a 5G network) via a corresponding antenna element. In the case of reception, each of the plurality of phase shifters 238 may shift the phase of the 5G Above6 RF signal received from the outside via a corresponding antenna element into the same or substantially the same phase. This may enable transmission or reception via beamforming between the electronic device 101 and the outside.

The second network 294 (e.g., 5G network) may operate independently (e.g., Stand-Along (SA)) from the first network 292 (e.g., a legacy network), or may operate by being connected thereto (e.g., Non-Stand Alone (NSA)). For example, in the 5G network, only an access network (e.g., 5G radio access network (RAN) or next generation RAN (NG RAN)) may exist, and a core network (e.g., next generation core (NGC)) may not exist. In this instance, the electronic device 101 may access an access network of the 5G network, and may access an external network (e.g., the Internet) under the control of the core network (e.g., an evolved packed core (EPC)) of the legacy network. Protocol information (e.g., LTE protocol information) for communication with the legacy network or protocol information (e.g., New Radio (NR) protocol information) for communication with the 5G network may be stored in the memory 230, and may be accessed by another component (e.g., the processor 120, the first communication processor 212, or the second communication processor 214).

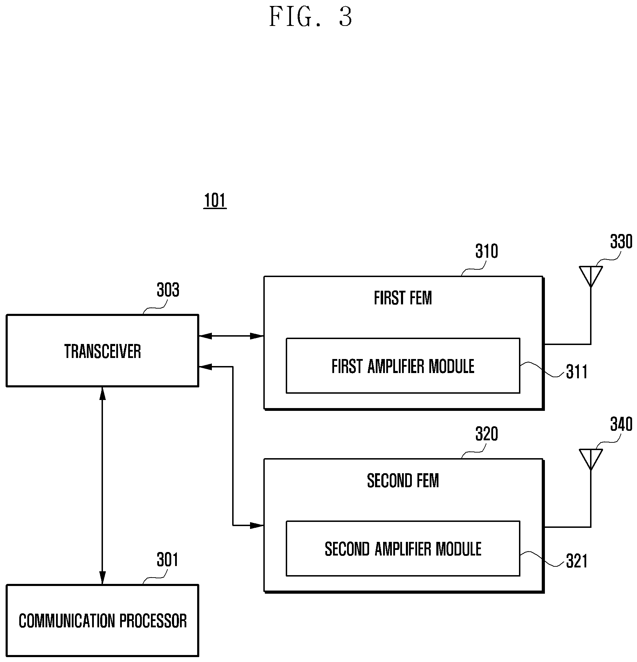

FIG. 3 is a block diagram of an electronic device according to various embodiments of the disclosure.

With reference to FIG. 3, the electronic device (e.g., electronic device 101 in FIG. 1) according to various embodiments of the disclosure may include a communication processor 301 (e.g., first communication processor 212 or second communication processor 214 in FIG. 2), a transceiver 303 (e.g., first RFIC 222, second RFIC 224, or fourth RFIC 228 in FIG. 2), a first front end module (FEM) 310 (e.g., first RFFE 232), a second FEM 320 (e.g., second RFFE 234), a first antenna 330 (e.g., first antenna module 242, second antenna module 244, or third antenna module 246 in FIG. 2), and/or a second antenna 340 (e.g., first antenna module 242, second antenna module 244, or third antenna module 246 in FIG. 2).

According to various embodiments of the disclosure, the communication processor 301 may receive or transmit control data or user data through short-range wireless communication (e.g., Wi-Fi or Bluetooth) or cellular wireless communication (e.g., 4G or 5G mobile communication). The communication processor 301 may establish a cellular communication connection with a base station by use of control data, and may transmit data from the application processor (e.g., processor 120 in FIG. 1) to the base station through established cellular communication or transfer data received from the base station to the application processor 120.

According to various embodiments of the disclosure, the transceiver 303 may perform various operations for processing a signal received from the communication processor 310. For example, the transceiver 303 may perform a modulation operation on a signal received from the communication processor 301. For example, the transceiver 303 may perform a frequency modulation operation to convert a baseband signal into a radio frequency (RF) signal used for cellular communication. The transceiver 303 may also perform a demodulation operation on a signal received through the communication circuit 350 from the outside. For example, the transceiver 303 may perform a frequency demodulation operation to convert a radio frequency (RF) signal into a baseband signal.

According to various embodiments of the disclosure, the first FEM 310 may include at least one RF chain for outputting a signal of a first frequency band through the first antenna 330. For example, an RF chain may refer to a set of various components included in a signal transfer path. The RF chain may include, for example, various components (e.g., amplifier, switch, or filter) that amplify a signal of the first frequency band from the transceiver 303 and filter the amplified signal.

According to various embodiments of the disclosure, the first FEM 310 may include a first amplifier module 311 for amplifying a signal of the first frequency band. The first amplifier module 311 may be a component included in the RF chain. The first amplifier module 311 may include one or more amplifiers that amplify signals of the first frequency band. For example, the first amplifier module 311 may be implemented in a multi-stage amplifier structure that amplifies a signal of the first frequency band in several stages.

According to various embodiments of the disclosure, the second FEM 320 may include at least one RF chain for outputting a signal of a second frequency band through the second antenna 340. For example, an RF chain may refer to a set of various components included in a signal transfer path. The RF chain may include, for example, various components (e.g., amplifier, switch, or filter) that amplify a signal of the second frequency band from the transceiver 303 and filter the amplified signal.

According to various embodiments of the disclosure, the second FEM 320 may include a second amplifier module 321 for amplifying a signal of the second frequency band. The second amplifier module 321 may be a component included in the RF chain. The second amplifier module 321 may include one or more amplifiers that amplify signals of the second frequency band. For example, the second amplifier module 321 may be implemented in a multi-stage amplifier structure that amplifies a signal of the second frequency band in several stages.

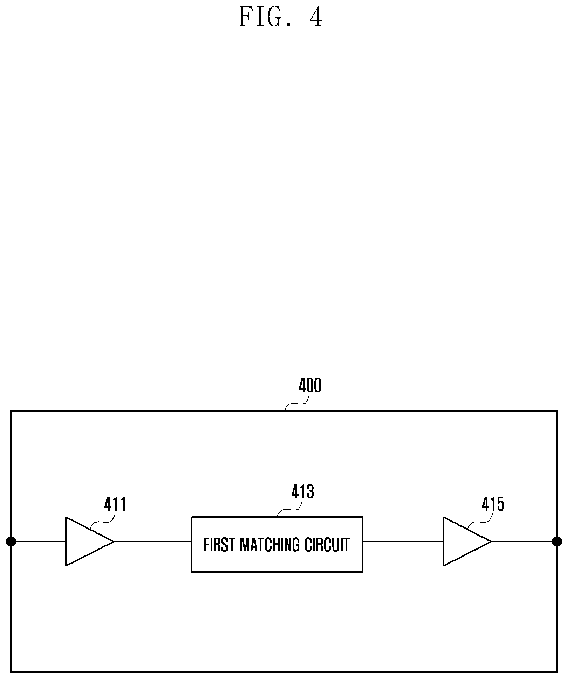

The first amplifier module 311 and the second amplifier module 321 will be described later with reference to FIG. 4.

FIG. 4 is a block diagram of an amplifier module according to various embodiments of the disclosure.

The amplifier module 400 (e.g., first amplifier module 311 and/or second amplifier module 321 in FIG. 3) according to various embodiments of the disclosure may include a first amplifier 411 for amplifying a signal received from the transceiver (e.g., transceiver 303 in FIG. 3), a second amplifier 415 for further amplifying the signal amplified by the first amplifier 411, and/or a first matching circuit 413 performing impedance matching between the first amplifier 411 and the second amplifier 415.

According to various embodiments of the disclosure, the amplifier module 400 may support multi-stage amplification. With reference to FIG. 4, the amplifier module 400 may support multi-stage amplification including first-stage amplification of an input signal by using the first amplifier 411 and second-stage amplification of the input signal by using the second amplifier 415. The number of amplifiers included in the amplifier module 400 may be determined by the designer in consideration of required strength of the signal to be amplified.

The first amplifier 411 may be an amplifier that amplifies a signal received from the transceiver 303. According to an embodiment, the first amplifier 411 may be implemented with a drive amplifier. The second amplifier 415 may be an amplifier that amplifies the signal amplified by the first amplifier 411 again. According to an embodiment, the second amplifier 415 may be an amplifier having a higher gain than that of the first amplifier 411. For example, the second amplifier 415 may be implemented with a power amplifier that can have a gain higher than that of a drive amplifier.

The first matching circuit 413 may be a circuit that performs inter-stage impedance matching indicating impedance matching between the first amplifier 411 performing first stage amplification and the second amplifier 415 performing second stage amplification.

According to various embodiments of the disclosure, the inter-stage matching circuit may be implemented in consideration of the frequency band of a signal to be input to the amplifier module 400. According to an embodiment, the first matching circuit 413 implemented considering that the amplifier module 400 is an amplifier module (e.g., first amplifier module 311 in FIG. 3) amplifying a signal of the first frequency band may be different from the first matching circuit 413 implemented considering that the amplifier module 400 is an amplifier module (e.g., second amplifier module 321 in FIG. 3) amplifying a signal of the second frequency band. When a signal of the second frequency band is amplified by using the amplifier module 400 including the first matching circuit 413 implemented considering that the amplifier module (e.g., first amplifier module 311 in FIG. 3) amplifies a signal of the first frequency band, performance of the amplifier module 400 for amplifying a signal of the second frequency band may be relatively decreased. For example, the amplifier module 400 may fail to achieve a required amplification gain for a signal of the second frequency band.

According to various embodiments of the disclosure, when a signal of the first frequency band is amplified by using the amplifier module 400 including the first matching circuit 413 implemented considering that the amplifier module (e.g., second amplifier module 321 in FIG. 3) amplifies a signal of the second frequency band, performance of the amplifier module 400 for amplifying a signal of the first frequency band may be relatively decreased. For example, the amplifier module 400 may fail to achieve a required amplification gain for a signal of the first frequency band. As another example, as the first matching circuit 413 is implemented inside the amplifier module 400, the electronic device 400 must have various types of amplifier modules to support communication using signals of various frequency bands.

Next, a description will be given of a communication circuit including an amplifier module that can be used in multiple frequency bands.

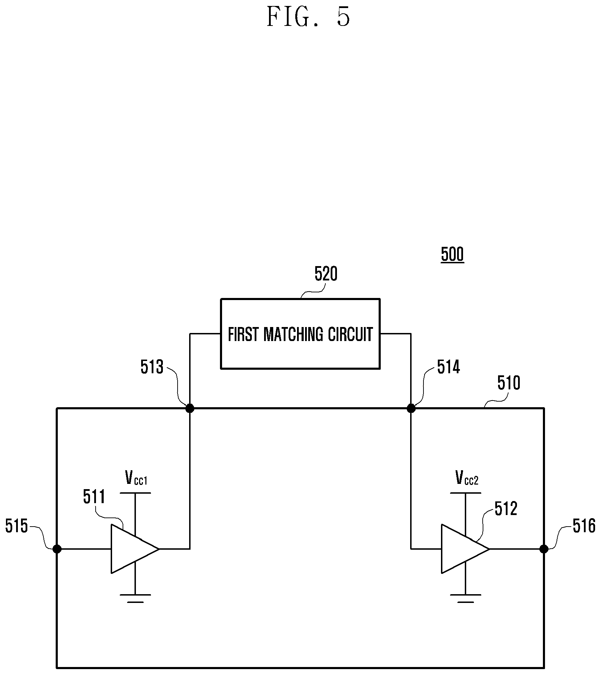

FIG. 5 is a diagram illustrating a communication circuit including an amplifier module and a first matching circuit performing impedance matching between a first amplifier and a second amplifier according to various embodiments of the disclosure.

The communication circuit 500 (e.g., first front-end module 310, second front-end module 320 in FIG. 3) according to various embodiments of the disclosure may include an amplifier module 510 (e.g., amplifier module 400 in FIG. 4) and/or a first matching circuit 520.

According to various embodiments of the disclosure, the amplifier module 510 may include a first amplifier 511 that amplifies a signal from the transceiver (e.g., transceiver 303 in FIG. 3), and a second amplifier 512 that amplifies the signal amplified by the first amplifier 511 again.

According to an embodiment, the first amplifier 511 may be an amplifier that amplifies a signal from the transceiver 303. The first amplifier 511 may be operated by a voltage Vcci applied by a power supply circuit (not shown) implemented in the communication circuit 500. According to an embodiment, the first amplifier 511 may be implemented with a drive amplifier.

According to an embodiment, the second amplifier 512 may be an amplifier that amplifies the signal amplified by the first amplifier 511 again. The second amplifier 512 may be operated by a voltage V_{CC2} applied by a power supply circuit (not shown) implemented in the communication circuit 500. According to an embodiment, the second amplifier 512 may be an amplifier having a gain higher than that of the first amplifier 511. For example, the second amplifier 512 may be implemented with a power amplifier that can have a gain higher than that of a drive amplifier.

According to an embodiment, the first matching circuit 520 may be a circuit that performs inter-stage impedance matching indicating impedance matching between the first amplifier 511 performing first stage amplification and the second amplifier 512 performing second stage amplification. The first matching circuit 520 performing impedance matching between the first amplifier 511 and the second amplifier 512 may increase the linearity of a signal output from the amplifier module 510.

According to an embodiment, the first matching circuit 520 may be disposed outside the amplifier module 510. For example, the outside of the amplifier module 510 may mean a position outside the package of the amplifier module 510. The first matching circuit 520 may be electrically connected to the amplifier module 510 through a first terminal 513 and a second terminal 514 of the amplifier module 510. A signal input through a third terminal 515 of the amplifier module 510 may be amplified by the first amplifier 511. The signal amplified by the first amplifier 511 may be output through the first terminal 513. The first terminal 513 may be an output terminal of the first amplifier 511. The signal output through the first terminal 513 may be input to the second amplifier 512 through the first matching circuit 520 and/or the second terminal 514. The second terminal 514 may be an input terminal of the second amplifier 512. The second amplifier 512 may amplify a signal received through the second terminal 514. The signal amplified by the second amplifier 512 may be output through a fourth terminal 516 and may be output through various components (e.g., filter and/or switch) to the antenna (e.g., first antenna 330 and/or second antenna 340).

According to various embodiments of the disclosure, the first matching circuit 520 may be implemented outside the amplifier module 510. As the first matching circuit 520 is implemented outside the amplifier module 510, the amplifier module 510 can amplify signals of various frequency bands. For example, when the amplifier module 510 is designed to amplify a signal of a first frequency band, the first matching circuit 520 may be implemented to perform impedance matching for the first frequency band. For another example, when the amplifier module 510 is designed to amplify a signal of a second frequency band, the first matching circuit 520 may be implemented to perform impedance matching for the second frequency band. As the first matching circuit 520 is implemented outside the amplifier module 510, tuning of the first matching circuit 520 may be facilitated according to the frequency band of a signal output from the communication circuit 500. The communication circuit 500 may amplify a signal by using the same amplifier module 510 regardless of the frequency band of the signal output from the communication circuit 500.

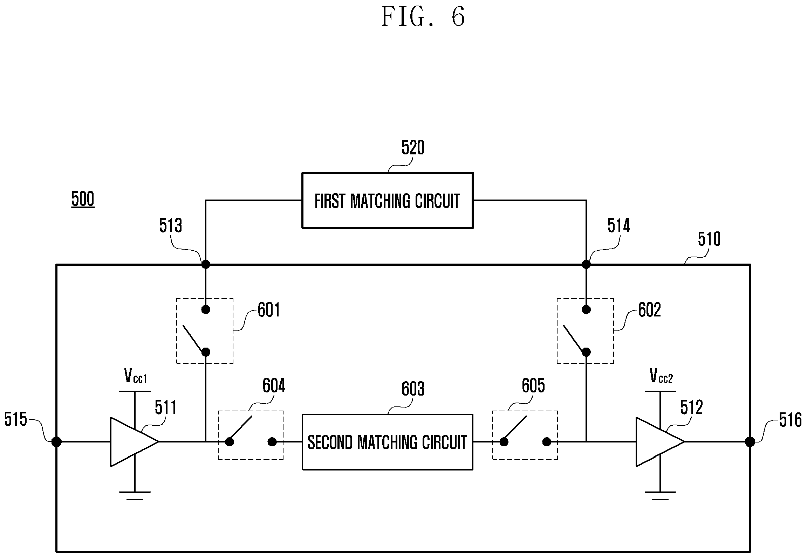

FIG. 6 is a block diagram of a communication circuit including an amplifier module capable of amplifying signals of plural frequency bands according to various embodiments of the disclosure.

The communication circuit 500 shown in FIG. 6 may include an amplifier module 510 capable of amplifying signals of at least two frequency bands.

The communication circuit 500 (e.g., first front-end module 310, second front-end module 320 in FIG. 3) according to various embodiments of the disclosure may include an amplifier module 510 (e.g., amplifier module 400 in FIG. 4), a first matching circuit 520, and/or a second matching circuit 603.

According to various embodiments of the disclosure, the amplifier module 510 may include a first amplifier 511 for amplifying a signal from the transceiver (e.g., transceiver 303 in FIG. 3), a second amplifier 512 for amplifying the signal amplified by the first amplifier 511 again, a first switch 601 for controlling the connection between the first amplifier 511 and the first matching circuit 520, a second switch 602 for controlling the connection between the second amplifier 512 and the first matching circuit 520, a third switch 604 for controlling the connection between the first amplifier 511 and the second matching circuit 603, and/or a fourth switch 605 for controlling the connection between the second amplifier 512 and the second matching circuit 603.

According to an embodiment, the first amplifier 511 may be an amplifier that amplifies a signal transferred by the transceiver 303. The first amplifier 511 may be operated by a voltage Vcci applied by a power supply circuit (not shown) implemented in the communication circuit 500. According to an embodiment, the first amplifier 511 may be implemented with a drive amplifier.

According to an embodiment, the second amplifier 512 may be an amplifier that amplifies the signal amplified by the first amplifier 511 again. The second amplifier 512 may be operated by a voltage V_{CC2} applied by a power supply circuit (not shown) implemented in the communication circuit 500. According to an embodiment, the second amplifier 512 may be an amplifier having a gain higher than that of the first amplifier 511. For example, the second amplifier 512 may be implemented with a power amplifier that may have a gain higher than that of a drive amplifier.

According to an embodiment, the first matching circuit 520 may be a circuit that performs inter-stage impedance matching indicating impedance matching between the first amplifier 511 performing first stage amplification and the second amplifier 512 performing second stage amplification. The first matching circuit 520 performing impedance matching between the first amplifier 511 and the second amplifier 512 may increase the linearity of a signal output from the amplifier module 510. The first matching circuit 520 may be a matching circuit that performs impedance matching between the first amplifier 511 and the second amplifier 512 when the amplifier module 510 amplifies a signal of the first frequency band.

According to an embodiment, the second matching circuit 603 may be a circuit that performs inter-stage impedance matching indicating impedance matching between the first amplifier 511 performing first stage amplification and the second amplifier 512 performing second stage amplification. The first matching circuit 520 performing impedance matching between the first amplifier 511 and the second amplifier 512 may increase the linearity of a signal output from the amplifier module 510. The second matching circuit 603 may be a matching circuit that performs impedance matching between the first amplifier 511 and the second amplifier 512 when the amplifier module 510 amplifies a signal of the second frequency band.

According to various embodiments of the disclosure, the communication circuit 500 may control connections between the first matching circuit 520, the first amplifier 511, and the second amplifier 512 based on the frequency band used by the communication circuit 500.

According to an embodiment, in response to transmission of a signal of the first frequency band, the communication processor (e.g., communication processor 301 in FIG. 3) may control the communication circuit 500 to output a signal of the first frequency band. For the communication circuit 500 to output a signal of the first frequency band, the communication processor 301 may control the communication circuit 500 so that the first matching circuit 520, the first amplifier 511, and the second amplifier 512 are connected. The communication processor 301 or the communication circuit 500 may control the first switch 601 and the second switch 602 to transition to a closed state, so that the first matching circuit 520, the first amplifier 511, and the second amplifier 512 can be electrically connected. The communication processor 301 or the communication circuit 500 may control the third switch 604 and/or the fourth switch 605 to transition to an open state. As the first matching circuit 520 is electrically connected to the first amplifier 511 and the second amplifier 512 when amplifying a signal of the first frequency band, it may realize impedance matching between the first amplifier 511 and the second amplifier 512.

A signal input through the third terminal 515 of the amplifier module 510 may be amplified by the first amplifier 511. A signal amplified by the first amplifier 511 may be output through the first switch 601 and the first terminal 513. The first terminal 513 may be an output terminal of the first amplifier 511. The signal output through the first terminal 513 may be input to the second amplifier 512 through the first matching circuit 520, the second terminal 514 and/or the second switch 602. The second terminal 514 may be an input terminal of the second amplifier 512. The second amplifier 512 may amplify a received signal. The signal amplified by the second amplifier 512 may be output through the fourth terminal 516, and may be output to the antenna (e.g., first antenna 330 and/or second antenna 340) through various components (e.g., filter and/or switch).

According to an embodiment, in response to transmission of a signal of the second frequency band, the communication processor (e.g., communication processor 301 in FIG. 3) may control the communication circuit 500 to output a signal of the second frequency band. For the communication circuit 500 to output a signal of the second frequency band, the communication processor 301 may control the communication circuit 500 so that the second matching circuit 603, the first amplifier 511, and the second amplifier 512 are electrically connected. The communication processor 301 or the communication circuit 500 may control the third switch 604 and the fourth switch 605 to transition to a closed state, so that the second matching circuit 603, the first amplifier 511, and the second amplifier 512 may be electrically connected. The communication processor 301 or the communication circuit 500 may control the first switch 601 and/or the second switch 602 to transition to an open state. The amplifier module 510 may realize impedance matching between the first amplifier 511 and the second amplifier 512 by using the second matching circuit 603 when amplifying a signal of the second frequency band.

A signal input through the third terminal 515 of the amplifier module 510 may be amplified by the first amplifier 511. The signal amplified by the first amplifier 511 may be input to the second amplifier 512 through the third switch 604, the second matching circuit 603 and/or the fourth switch 605. The second amplifier 512 may amplify a received signal. The signal amplified by the second amplifier 512 may be output through the fourth terminal 516, and may be output to the antenna (e.g., first antenna 330 and/or second antenna 340) through various components (e.g., filter and/or switch).

According to various embodiments of the disclosure, the first matching circuit 520 may be implemented outside the amplifier module 510. As the first matching circuit 520 is implemented outside the amplifier module 510, the amplifier module 510 can amplify signals of various frequency bands. For example, when a signal of the first frequency band is amplified, the first amplifier 511 and the second amplifier 512 may be electrically connected to the first matching circuit 520. When a signal of the second frequency band is amplified, the first amplifier 511 and the second amplifier 512 may be connected to the second matching circuit 603 instead of the first matching circuit 520. The amplifier module 510 may support amplification of signals of more various frequency bands through the connection of the first matching circuit 520 disposed outside the amplifier module 510.

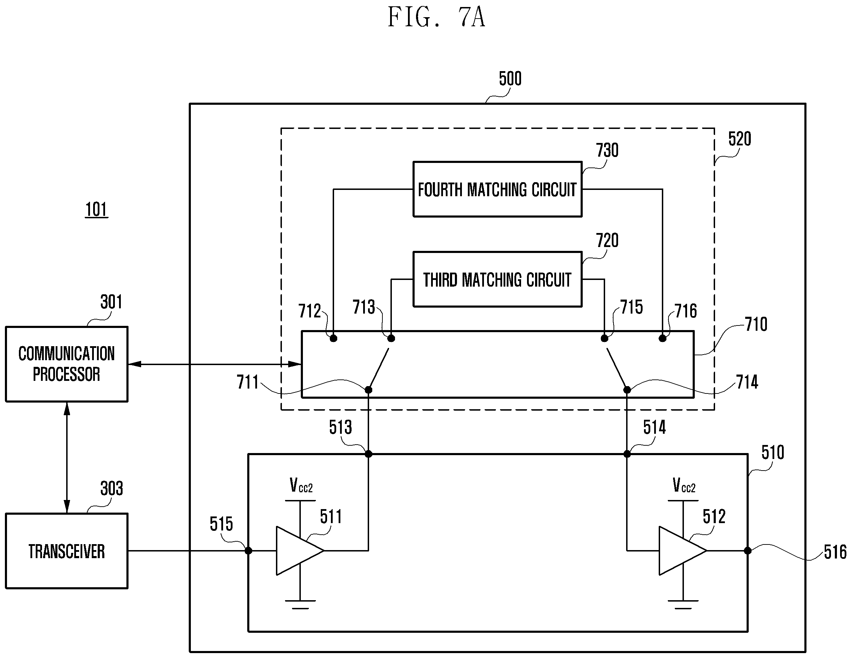

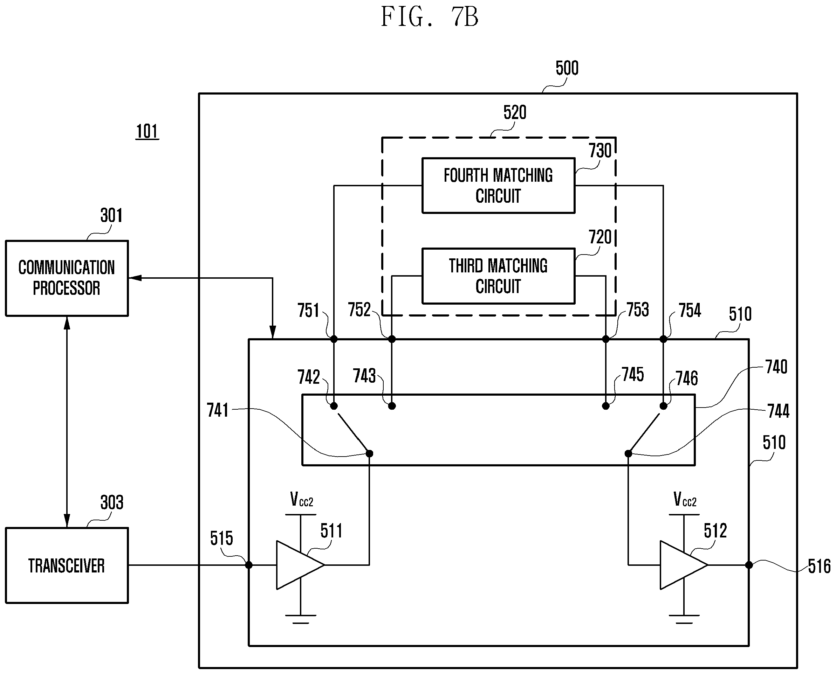

FIG. 7A and 7B are block diagrams of an electronic device including an amplifier module capable of amplifying signals of plural frequency bands according to various embodiments of the disclosure.

According to various embodiments of the disclosure, the electronic device (e.g., electronic device 101 in FIG. 1) may include a communication processor 301 (e.g., first communication processor 212 or second communication processor 214 in FIG. 2), a transceiver 303 (e.g., first RFIC 222, second RFIC 224, or fourth RFIC 228 in FIG. 2), and a communication circuit (e.g., communication circuit 500 in FIG. 5).

According to various embodiments of the disclosure, the communication processor 301 may receive or transmit control data or user data through short-range wireless communication (e.g., Wi-Fi or Bluetooth) or cellular wireless communication (e.g., 4G or 5G mobile communication). The communication processor 301 may establish a cellular communication connection with a base station by use of control data, and may transmit data from the application processor (e.g., processor 120 in FIG. 1) to the base station through established cellular communication or transfer data received from the base station to the application processor 120.

According to various embodiments of the disclosure, the transceiver 303 may perform various operations for processing a signal received from the communication processor 310. For example, the transceiver 303 may perform a modulation operation on a signal received from the communication processor 301. For example, the transceiver 303 may perform a frequency modulation operation to convert a baseband signal into a radio frequency (RF) signal used for cellular communication. The transceiver 303 may also perform a demodulation operation on a signal received through the communication circuit 350 from the outside. For example, the transceiver 303 may perform a frequency demodulation operation to convert a radio frequency (RF) signal into a baseband signal.

The communication circuit 500 (e.g., first front-end module 310, second front-end module 320 in FIG. 3) according to various embodiments of the disclosure may include an amplifier module 510 (e.g., amplifier module 400 in FIG. 4) and/or a first matching circuit 520.

According to various embodiments of the disclosure, the amplifier module 510 may include a first amplifier 511 that amplifies a signal from the transceiver (e.g., transceiver 303 in FIG. 3), and a second amplifier 512 that amplifies the signal amplified by the first amplifier 411 again.

According to an embodiment, the first amplifier 511 may be an amplifier that amplifies a signal from the transceiver 303. The first amplifier 511 may be operated by a voltage Vcci applied by a power supply circuit (not shown) implemented in the communication circuit 500. According to an embodiment, the first amplifier 511 may be implemented with a drive amplifier.

According to an embodiment, the second amplifier 512 may be an amplifier that amplifies the signal amplified by the first amplifier 511 again. The second amplifier 512 may be operated by a voltage V_{CC2} applied by a power supply circuit (not shown) implemented in the communication circuit 500. According to an embodiment, the second amplifier 512 may be an amplifier having a gain higher than that of the first amplifier 511. For example, the second amplifier 512 may be implemented with a power amplifier that can have a gain higher than that of a drive amplifier.

According to an embodiment, the first matching circuit 520 may be a circuit that performs inter-stage impedance matching indicating impedance matching between the first amplifier 511 performing first stage amplification and the second amplifier 512 performing second stage amplification. The first matching circuit 520 performing impedance matching between the first amplifier 511 and the second amplifier 512 may increase the linearity of a signal output from the amplifier module 510.

According to various embodiments of the disclosure, the first matching circuit 520 may include plural matching circuits to perform impedance matching for the corresponding frequency bands. According to an embodiment, the first matching circuit 520 may include a third matching circuit 720 for performing impedance matching between the first amplifier 511 and the second amplifier 512 when the amplifier module 510 amplifies a signal of the first frequency band, and a fourth matching circuit 730 for performing impedance matching between the first amplifier 511 and the second amplifier 512 when the amplifier module 510 amplifies a signal of the second frequency band.

According to an embodiment, the first matching circuit 520 may be disposed outside the amplifier module 510. The first matching circuit 520 may be electrically connected to the amplifier module 510 through a first terminal 513 and a second terminal 514 of the amplifier module 510. A signal input through a third terminal 515 of the amplifier module 510 may be amplified by the first amplifier 511.

With reference to FIG. 7A, the first matching circuit 520 may include a fifth switch 710 for connecting one of the third matching circuit 720 and the fourth matching circuit 730 to the amplifier module 510. According to an embodiment, the fifth switch 710 may include a fifth terminal 711 connected to the first terminal 513 of the amplifier module 510, a sixth terminal 712 connected to the fourth matching circuit 730, a seventh terminal 713 connected to the third matching circuit 720, an eighth terminal 714 connected to the second terminal 514 of the amplifier module 510, a ninth terminal 715 connected to the third matching circuit 720, and/or a tenth terminal 716 connected to the fourth matching circuit 730.

According to various embodiments of the disclosure, the communication processor 301 or the communication circuit 500 may control the connection between the first matching circuit 520 and the amplifier module 510 based on the frequency band used by the communication circuit 500.

According to an embodiment, in response to transmission of a signal of the first frequency band, the communication processor (e.g., communication processor 301 in FIG. 3) may control the communication circuit 500 to output a signal of the first frequency band. For the communication circuit 500 to output a signal of the first frequency band, the communication processor 301 may control the communication circuit 500 so that the third matching circuit 720 and the amplifier module 510 are electrically connected. The communication circuit 500 may control the fifth switch 710 so that the fifth terminal 711 and the seventh terminal 713 are electrically connected, and the eighth terminal 714 and the ninth terminal 715 are electrically connected. The amplifier module 510 is electrically connected to the third matching circuit 720 when amplifying a signal of the first frequency band, which can realize impedance matching between the first amplifier 511 and the second amplifier 512.

According to an embodiment, in response to transmission of a signal of the second frequency band, the communication processor (e.g., communication processor 301 in FIG. 3) may control the communication circuit 500 to output a signal of the second frequency band. For the communication circuit 500 to output a signal of the second frequency band, the communication processor 301 may control the communication circuit 500 so that the fourth matching circuit 730 and the amplifier module 510 are electrically connected. The communication circuit 500 may control the fifth switch 710 so that the fifth terminal 711 and the sixth terminal 712 are electrically connected, and the eighth terminal 714 and the tenth terminal 716 are electrically connected. The amplifier module 510 is electrically connected to the fourth matching circuit 730 when amplifying a signal of the second frequency band, which can realize impedance matching between the first amplifier 511 and the second amplifier 512.

According to various embodiments of the disclosure, to control the fifth switch 710, the communication processor 301 may transmit a control signal for the fifth switch 710 to the fifth switch 710. In this case, the communication processor 301 and the fifth switch 710 may be electrically connected.

With reference to FIG. 7B, a sixth switch 740 (e.g., fifth switch 710 in FIG. 7A) for connecting one of the third matching circuit 720 and the fourth matching circuit 730 to the amplifier module 510 may be included in the amplifier module 510. When the sixth switch 740 is implemented in the amplifier module 510, the communication processor 301 may transmit a control signal for the sixth switch 740 to the sixth switch 740 through the amplifier module 510.

According to various embodiments of the disclosure, the third matching circuit 720 may be connected to the amplifier module 510 through an eleventh terminal 752 and a twelfth terminal 753. The fourth matching circuit 730 may be connected to the amplifier module 510 through a thirteenth terminal 751 and a fourteenth terminal 754.

According to various embodiments of the disclosure, the amplifier module 510 may include a sixth switch 740 for electrically connecting one of the third matching circuit 720 and the fourth matching circuit 730 to the first amplifier 511 and the second amplifier 512. The sixth switch 740 may include a fifteenth terminal 741 connected to the first amplifier 511, a sixteenth terminal 742 connected to the thirteenth terminal 751, a seventeenth terminal 743 connected to the eleventh terminal 752, an eighteenth terminal 744 connected to the second amplifier 512, a nineteenth terminal 745 connected to the twelfth terminal 753, and/or a twentieth terminal 746 connected to the fourteenth terminal 754.

According to various embodiments of the disclosure, the communication processor 301 or the communication circuit 500 may control the electrical connection between the first matching circuit 520, the first amplifier 511, and the second amplifier 512 based on the frequency band used by the communication circuit 500.

According to an embodiment, in response to transmission of a signal of the first frequency band, the communication processor 301 may control the communication circuit 500 to output a signal of the first frequency band. For the communication circuit 500 to output a signal of the first frequency band, the communication processor 301 may control the communication circuit 500 so that the third matching circuit 720 is electrically connected to the first amplifier 511 and/or the second amplifier 512. The communication circuit 500 may control the sixth switch 740 so that the fifteenth terminal 741 and the seventeenth terminal 743 are electrically connected, and the eighteenth terminal 744 and the nineteenth terminal 745 are electrically connected. The amplifier module 510 is electrically connected to the third matching circuit 720 when amplifying a signal of the first frequency band, which can realize impedance matching between the first amplifier 511 and the second amplifier 512.

According to an embodiment, in response to transmission of a signal of the second frequency band, the communication processor 301 may control the communication circuit 500 to output a signal of the second frequency band. For the communication circuit 500 to output a signal of the second frequency band, the communication processor 301 may control the communication circuit 500 so that the fourth matching circuit 730 is connected to the first amplifier 511 and/or the second amplifier 512. The communication circuit 500 may control the sixth switch 740 so that the fifteenth terminal 741 and the sixteenth terminal 742 are electrically connected, and the eighteenth terminal 744 and the twentieth terminal 746 are electrically connected. The amplifier module 510 is electrically connected to the fourth matching circuit 730 when amplifying a signal of the second frequency band, which can realize impedance matching between the first amplifier 511 and the second amplifier 512.

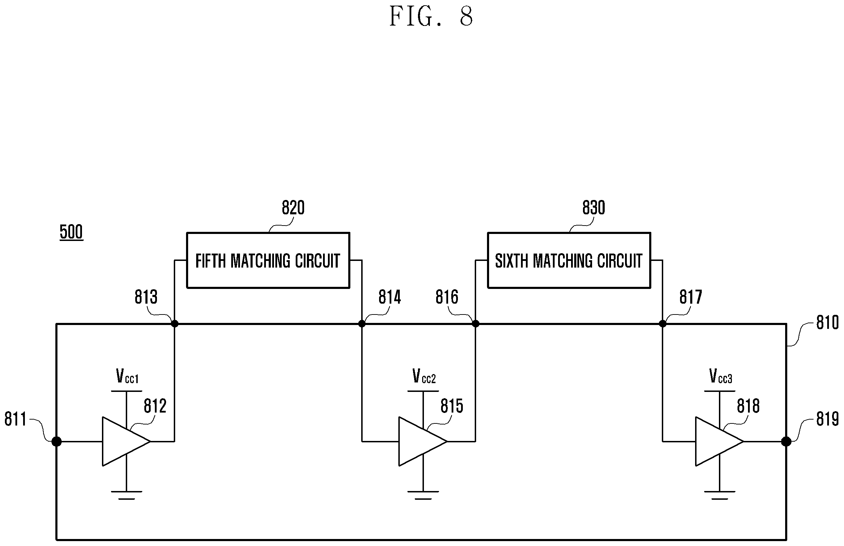

FIG. 8 is a block diagram of a communication circuit including an amplifier module according to various embodiments of the disclosure.

Various embodiments of the disclosure may also be applied to an amplifier module 810 (e.g., amplifier module 500 in FIG. 5) supporting multi-stage amplification.

FIG. 8 is a block diagram of the amplifier module 800 supporting three-stage amplification, and the amplifier module 810 may include a first amplifier 812 (e.g., first amplifier 511 in FIG. 5), a second amplifier 815 (e.g., first amplifier 511 in FIG. 5), and/or a third amplifier 818 (e.g., second amplifier 512 in FIG. 5).

According to an embodiment, the first amplifier 812 may be an amplifier that amplifies a signal from the transceiver 303. The first amplifier 812 whose input port is connected to a first terminal 811 may amplify a signal from the transceiver 303. The first amplifier 812 may be operated by a voltage Vcci applied by a power supply circuit (not shown) implemented in the communication circuit 500. According to an embodiment, the first amplifier 812 may be implemented with a drive amplifier.

According to various embodiments of the disclosure, the signal amplified by the first amplifier 812 may be output through a second terminal 813 of the amplifier module 810. The second terminal 813 may be an output terminal of the first amplifier 812. The signal output through the second terminal 813 may be input to the second amplifier 815 through a fifth matching circuit 820 (e.g., first matching circuit 520 in FIG. 5) and/or a third terminal 814. The third terminal 814 may be an input terminal of the second amplifier 815.

According to an embodiment, the fifth matching circuit 820 may be a circuit that performs inter-stage impedance matching indicating impedance matching between the first amplifier 812 performing first stage amplification and the second amplifier 815 performing second stage amplification. The fifth matching circuit 820 performing impedance matching between the first amplifier 812 and the second amplifier 815 may increase the linearity of a signal output from the amplifier module 810.

According to one embodiment, the fifth matching circuit 820 may be disposed outside the amplifier module 810. The fifth matching circuit 820 may be electrically connected to the amplifier module 810 through the second terminal 813 and the third terminal 814 of the amplifier module 810.

The second amplifier 815 may be an amplifier that amplifies the signal amplified by the first amplifier 811 again. The second amplifier 815 whose input port is connected to the third terminal 813 may amplify the signal amplified by the first amplifier 812. The second amplifier 815 may be operated by a voltage V_{CC2} applied by a power supply circuit (not shown) implemented in the communication circuit 500. According to an embodiment, the second amplifier 815 may be an amplifier having a gain higher than that of the first amplifier 812.

According to various embodiments of the disclosure, the signal amplified by the second amplifier 815 may be output through the fourth terminal 816 of the amplifier module 810. The fourth terminal 816 may be an output terminal of the second amplifier 815. The signal amplified by the second amplifier 815 may be input to the third amplifier 818 through the sixth matching circuit 830 (e.g., first matching circuit 520 in FIG. 5) and/or the fifth terminal 817. The fifth terminal 817 may be an input terminal of the third amplifier 818.

According to an embodiment, the sixth matching circuit 830 may be a circuit that performs inter-stage impedance matching indicating impedance matching between the second amplifier 815 performing second stage amplification and the third amplifier 818 performing third stage amplification. The sixth matching circuit 830 performing impedance matching between the second amplifier 815 and the third amplifier 818 may increase the linearity of a signal output from the amplifier module 810.

According to an embodiment, the sixth matching circuit 830 may be disposed outside the amplifier module 810. The fifth matching circuit 820 may be electrically connected to the amplifier module 810 through the fourth terminal 816 and the fifth terminal 817 of the amplifier module 810.

According to an embodiment, the third amplifier 818 may be an amplifier that amplifies the signal amplified by the second amplifier 815 again. The third amplifier 818 may be operated by a voltage V_{CC3} applied by a power supply circuit (not shown) implemented in the communication circuit 500. According to an embodiment, the third amplifier 818 may be an amplifier having a gain higher than that of the second amplifier 815. For example, the third amplifier 818 may be implemented with a power amplifier that may have a gain higher than that of a drive amplifier.

According to various embodiments of the disclosure, the fifth matching circuit 820 and/or the sixth matching circuit 830 may be implemented outside the amplifier module 810. The fifth matching circuit 820 and/or the sixth matching circuit 830 implemented outside the amplifier module 810 may enable the amplifier module 810 to amplify signals of various frequency bands. For example, when the amplifier module 810 is designed to amplify a signal of the first frequency band, the fifth matching circuit 820 and/or the sixth matching circuit 830 may be implemented to perform impedance matching for the first frequency band. For another example, when the amplifier module 810 is designed to amplify a signal of the second frequency band, the fifth matching circuit 820 and/or the sixth matching circuit 830 may be implemented to perform impedance matching for the second frequency band. The fifth matching circuit 820 and/or the sixth matching circuit 830 implemented outside the amplifier module 810 may facilitate tuning of the fifth matching circuit 820 and/or the sixth matching circuit 830 according to the frequency band of a signal output by the communication circuit 500. The communication circuit 500 may perform signal amplification by using the same amplifier module 810 regardless of the frequency band of a signal output by the communication circuit 500.

A communication circuit according to various embodiments of the disclosure may include: an amplifier module including a first amplifier and a second amplifier for amplifying a signal amplified by the first amplifier; and a first matching circuit disposed outside the amplifier module and performing impedance matching between the first amplifier and the second amplifier, wherein the amplifier module may include a first terminal for outputting a signal amplified by the first amplifier to the outside, and a second terminal for a signal input to the second amplifier, and wherein the first matching circuit may be connected to the amplifier module through the first terminal and the second terminal.

In the communication circuit according to various embodiments of the disclosure, the first matching circuit and the amplifier module may be connected based on the frequency band used by the communication circuit.

The communication circuit according to various embodiments of the disclosure may further include a second matching circuit performing impedance matching between the first amplifier and the second amplifier, and **the communication circuit may be configured so that** one of the first matching circuit and the second matching circuit is connected between the first amplifier and the second amplifier based on the frequency band of a signal input to the communication circuit.

The communication circuit according to various embodiments of the disclosure may be configured so that the first amplifier and/or the second amplifier are connected to the first matching circuit in response to a signal of a first frequency band input to the amplifier module.

The communication circuit according to various embodiments of the disclosure may be configured so that the first amplifier and/or the second amplifier are connected to the second matching circuit in response to a signal of a second frequency band input to the amplifier module.

In the communication circuit according to various embodiments of the disclosure, the second matching circuit may be disposed inside the amplifier module.

In the communication circuit according to various embodiments of the disclosure, the amplifier module may further include a first switch controlling a connection between the first amplifier and the first matching circuit, a second switch controlling a connection between the second amplifier and the first matching circuit, a third switch controlling a connection between the first amplifier and the second matching circuit, and a fourth switch controlling a connection between the second amplifier and the second matching circuit; the communication circuit may control the first switch, the second switch, the third switch, and/or the fourth switch so that the first amplifier and/or the second amplifier are connected to the first matching circuit in response to a signal of the first frequency band input to the amplifier module.

The communication circuit according to various embodiments of the disclosure may control the first switch, the second switch, the third switch, and/or the fourth switch so that the first amplifier and/or the second amplifier are connected to the second matching circuit in response to a signal of the second frequency band input to the amplifier module.

In the communication circuit according to various embodiments of the disclosure, the first matching circuit may include a third matching circuit performing impedance matching between the first amplifier and the second amplifier when a signal of the first frequency band is input to the amplifier module, and a fourth matching circuit performing impedance matching between the first amplifier and the second amplifier when a signal of the second frequency band is input to the amplifier module; the communication circuit may connect one of the third matching circuit and the fourth matching circuit to the amplifier module based on the frequency band of a signal input to the communication circuit.

The communication circuit according to various embodiments of the disclosure may further include a fifth switch for selectively connecting one of the third matching circuit and the fourth matching circuit to the amplifier module, and the fifth switch may be disposed inside or outside the amplifier module.

An electronic device according to various embodiments of the disclosure may include: a communication processor; a transceiver; and a communication circuit, wherein the communication circuit may include an amplifier module including a first amplifier and a second amplifier for amplifying a signal amplified by the first amplifier, and a first matching circuit disposed outside the amplifier module and performing impedance matching between the first amplifier and the second amplifier, wherein the amplifier module may include a first terminal for outputting a signal amplified by the first amplifier to the outside, and a second terminal for a signal input to the second amplifier, and wherein the first matching circuit may be connected to the amplifier module through the first terminal and the second terminal.

In the electronic device according to various embodiments of the disclosure, the communication processor may be configured to control a connection between the first matching circuit and the amplifier module based on the frequency band of a signal D input to the communication circuit.

In the electronic device according to various embodiments of the disclosure, the communication circuit may further include a second matching circuit that performs impedance matching between the first amplifier and the second amplifier; the communication processor may be configured to control the communication circuit, based on the frequency band of a signal input to the communication circuit, so that one of the first matching circuit and the second matching circuit is connected between the first amplifier and the second amplifier.

In the electronic device according to various embodiments of the disclosure, the communication processor may be configured to control the communication circuit so that the first amplifier and/or the second amplifier are connected to the first matching circuit in response to a signal of a first frequency band input to the amplifier module.

In the electronic device according to various embodiments of the disclosure, the communication processor may be configured to control the communication circuit so that the first amplifier and/or the second amplifier are connected to the second matching circuit in response to a signal of a second frequency band input to the amplifier module.

In the electronic device according to various embodiments of the disclosure, the second matching circuit may be disposed inside the amplifier module.

In the electronic device according to various embodiments of the disclosure, the amplifier module may further include a first switch controlling a connection between the first amplifier and the first matching circuit, a second switch controlling a connection between the second amplifier and the first matching circuit, a third switch controlling a connection between the first amplifier and the second matching circuit, and a fourth switch controlling a connection between the second amplifier and the second matching circuit; the communication processor may control the first switch, the second switch, the third switch, and/or the fourth switch so that the first amplifier and/or the second amplifier are connected to the first matching circuit in response to a signal of the first frequency band input to the amplifier module.

In the electronic device according to various embodiments of the disclosure, the communication processor may control the first switch, the second switch, the third switch, and/or the fourth switch so that the first amplifier and/or the second amplifier are connected to the second matching circuit in response to a signal of the second frequency band input to the amplifier module.

In the electronic device according to various embodiments of the disclosure, the first matching circuit may include a third matching circuit performing impedance matching between the first amplifier and the second amplifier when a signal of the first frequency band is input to the amplifier module, and a fourth matching circuit performing impedance matching between the first amplifier and the second amplifier when a signal of the second frequency band is input to the amplifier module; the communication processor may control the communication circuit to connect one of the third matching circuit and the fourth matching circuit to the amplifier module based on the frequency band of a signal input to the communication circuit.

In the electronic device according to various embodiments of the disclosure, the communication circuit may further include a fifth switch for selectively connecting one of the third matching circuit and the fourth matching circuit to the amplifier module, and the fifth switch may be disposed inside or outside the amplifier module.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101) . For example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A communication circuit comprising:
an amplifier module including a first amplifier and a second amplifier for amplifying a signal amplified by the first amplifier; and
a first matching circuit disposed outside the amplifier module and performing impedance matching between the first amplifier and the second amplifier,
wherein the amplifier module includes a first terminal for outputting a signal amplified by the first amplifier to an outside, and a second terminal for a signal input to the second amplifier,
wherein the first matching circuit is connected to the amplifier module through the first terminal and the second terminal.

2. The communication circuit of claim 1, wherein **the communication circuit is configured to** connect the first matching circuit and the amplifier module based on a frequency band used by the communication circuit.

3. The communication circuit of claim 1, further comprising a second matching circuit performing impedance matching between the first amplifier and the second amplifier, and wherein the communication circuit is configured in a manner that one of the first matching circuit and the second matching circuit is connected between the first amplifier and the second amplifier based on a frequency band of a signal input to the communication circuit.

4. The communication circuit of claim 3, wherein the communication circuit is configured in a manner that the first amplifier and/or the second amplifier are connected to the first matching circuit in response to a signal of a first frequency band input to the amplifier module.

5. The communication circuit of claim 3, wherein the communication circuit is configured in a manner that the first amplifier and/or the second amplifier are connected to the second matching circuit in response to a signal of a second frequency band input to the amplifier module.

6. The communication circuit of claim 3, wherein the second matching circuit is disposed inside the amplifier module.

7. The communication circuit of claim 3, wherein:
the amplifier module further includes a first switch controlling a connection between the first amplifier and the first matching circuit, a second switch controlling a connection between the second amplifier and the first matching circuit, a third switch controlling a connection between the first amplifier and the second matching circuit, and a fourth switch controlling a connection between the second amplifier and the second matching circuit; and
the communication circuit controls, in response to a signal of the first frequency band input to the amplifier module, the first switch, the second switch, the third switch, and/or the fourth switch in a manner that the first amplifier and/or the second amplifier are connected to the first matching circuit.

8. The communication circuit of claim 7, wherein the communication circuit controls, in response to a signal of the second frequency band input to the amplifier module, the first switch, the second switch, the third switch, and/or the fourth switch in a manner that the first amplifier and/or the second amplifier are connected to the second matching circuit.

9. The communication circuit of claim 1, wherein:
the first matching circuit includes a third matching circuit performing impedance matching between the first amplifier and the second amplifier when a signal of the first frequency band is input to the amplifier module, and a fourth matching circuit performing impedance matching between the first amplifier and the second amplifier when a signal of the second frequency band is input to the amplifier module; and
the communication circuit connects one of the third matching circuit and the fourth matching circuit to the amplifier module based on the frequency band of a signal input to the communication circuit.

10. The communication circuit of claim 9, further comprising a fifth switch for selectively connecting one of the third matching circuit and the fourth matching circuit to the amplifier module, and wherein the fifth switch is disposed inside or outside the amplifier module.

11. An electronic device comprising:
a communication processor;
a transceiver; and
a communication circuit,
wherein the communication circuit includes an amplifier module that includes a first amplifier and a second amplifier for amplifying a signal amplified by the first amplifier, and a first matching circuit disposed outside the amplifier module and performing impedance matching between the first amplifier and the second amplifier,
wherein the amplifier module includes a first terminal for outputting a signal amplified by the first amplifier to an outside, and a second terminal for a signal input to the second amplifier,
wherein the first matching circuit is connected to the amplifier module through the first terminal and the second terminal.

12. The electronic device of claim 11, wherein the communication processor is configured to control a connection between the first matching circuit and the amplifier module based on a frequency band of a signal input to the communication circuit.

13. The electronic device of claim 11, wherein:
the communication circuit further includes a second matching circuit that performs impedance matching between the first amplifier and the second amplifier; and
the communication processor is configured to control the communication circuit, based on the frequency band of a signal input to the communication circuit, in a manner that one of the first matching circuit and the second matching circuit is connected between the first amplifier and the second amplifier.

14. The electronic device of claim 13, wherein, in response to a signal of a first frequency band input to the amplifier module, the communication processor is configured to control the communication circuit in a manner that the first amplifier and/or the second amplifier are connected to the first matching circuit.

15. The electronic device of claim 13, wherein, in response to a signal of a second frequency band input to the amplifier module, the communication processor is configured to control the communication circuit in a manner that the first amplifier and/or the second amplifier are connected to the second matching circuit.
